# EUROPEAN PATENT SPECIFICATION

(11) **EP 2 251 903 B1**
(45) Date of publication and mention of the grant of the patent: **29.03.2017**
(21) Application number: 09305435.1
(22) Date of filing: 14.05.2009
(51) Int. Cl.: H01L 23/40

(54) **Heat sink mounting method**
Kühlkörpermontageverfahren
Procédé de montage de dissipateur de chaleur

(43) Date of publication of application: 17.11.2010
(73) Proprietor: Thompson Licensing, 92100 Boulogne Billancourt (FR)
(72) Inventor: Kiew, Kian Choy, 92648 Boulogne cedex (FR); Shi, Ji Wei, 92648 Boulogne cedex (FR); Huang, Wen Xin, 92648 Boulogne cedex (FR)
(74) Representative: Novagraaf Technologies

(56) References cited:
- WO-A-01/78138
- JP-A- 8 162 575
- US-A- 5 926 371
- US-A1- 2003 159 819
- US-A1- 2004 174 682

## Description

### FIELD OF THE INVENTION

This invention relates to mounting technology, especially to mounting a heat sink to a printed circuit board.

### BACKGROUND OF THE INVENTION

Traditionally, when a circuit board component, e.g. an integrated circuit (IC) package which is for example soldered to a printed circuit board in Ball Grid Array (BGA) way (called BGA IC package hereafter), is used in an electronic device, it generates huge heat. As this huge heat accumulates, the circuit board component will be damaged, and even fail. To solve this problem, a heat sink is usually mounted on the surface of the circuit board component to dissipate the heat.

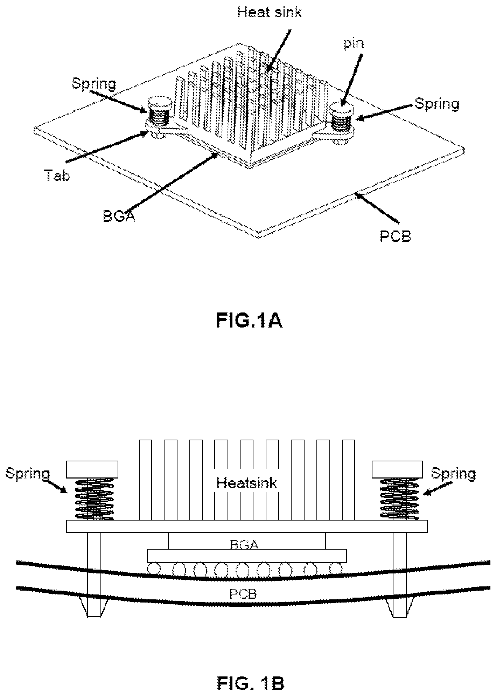

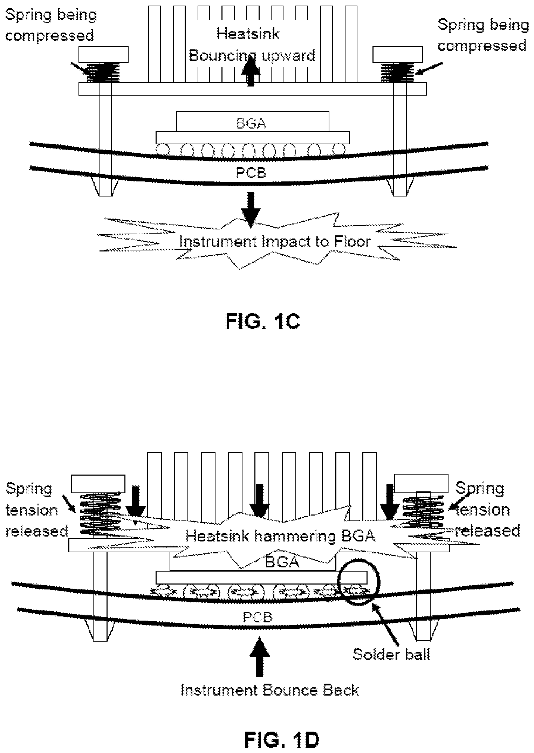

Figs.1A, 1B, 1C and 1D show a conventional frequently used example which uses two arrow-ended pins to lock a heat sink attached on a BGA IC package to a PCB with a helical spring coiling around the pole of each pin between the head of the pin and the tab of the heat sink. Fig.1A is the isometric view. Fig.1B is a front view showing the case when the heat sink is statically mounted on the BGA IC package and further on the PCB. However, when the heat sink is mounted on the BGA IC package, it will further increase the weight on the PCB and this will generate a strain on the solder ball connections of Ball Grid Array (BGA) IC package. From Fig.1B, it can be seen that the PCB is bended due to the increase of weight on top of the PCB. In a worse condition, when the whole assembled device/instrument (heat sink, BGA package, and PCB) drops for example to the floor, since the heat sink is locked to the PCB by the pins, due to the elasticity of the helical springs and the BGA. Fig. 1C illustrates the situation when the helical spring is compressed due to the hit to for example the floor. Fig.1D shows the situation when the helical spring tension is released and the heat sink hammers the BGA IC package.

An example of the above solution is described in US2003/159819A1, which describe a solution for attachment of a heat dissipating assembly to a printed circuit board by mechanical members such as tabs, pins and springs.

US5,926,371 suggests the usage of seal between a lip in bottom surface of a cap structure of a heat transfer apparatus and the component side of a PCB

### SUMMARY OF THE INVENTION

In an aspect, a heat dissipating assembly is provided, which includes a printed circuit board; an electronic device, attached to the printed circuit board; a heat dissipating apparatus, bottom of which is attached to the surface of the electronic device and has at least a part exposed to the printed circuit board; and at least one adhesive element, disposed between the part of the bottom exposed to the printed circuit board and the printed circuit board to make the heat dissipating apparatus adhere to the printed circuit board.

Further, the heat dissipating apparatus comprises two tabs extending from the bottom and paralleling the printed circuit board and two pins inserted through two tabs respectively to further lock the heat dissipating apparatus to the printed circuit board. When the bottom of the heat sink is of round shape, the two tabs extend diametrically from the bottom. Alternatively, the two tabs extend diagonally from the bottom when the bottom 21 is of rectangular shape.

When the bottom of the heat sink is rectangular shape, the at least one adhesive element may be disposed at the two corners of the bottom of the heat dissipating apparatus which do not have a tab to make the heat dissipating apparatus adhere to the printed circuit board.

Alternatively, the at least one adhesive element may be disposed at the four corners and the edges of the heat dissipating apparatus to make the heat dissipating apparatus adhere to the printed circuit board.

Above mentioned adhesive element may be epoxy glue and can't have chemical reaction with the PCB and the heat sink.

The electronic device is a Ball Grid Array package, a Quad Flat No leads package, a Small Outline Package, or a Chip Support Package.

In another aspect, a method for mounting a heat dissipating apparatus to a printed circuit board is described. The method comprises steps of attaching an electronic device to the printed circuit board; mounting the heat dissipating apparatus on the electronic device, the bottom of the heat dissipating apparatus being attached to the surface of the electronic device and having at least a part exposed to the printed circuit board; and disposing adhesive between the part of the bottom exposed to the printed circuit board and the printed circuit board to make the heat dissipating apparatus adhere to the printed circuit board.

Further, before the step of disposing adhesive, there is a step of locking the heat dissipating apparatus to the printed circuit board by using two pins through two tabs extending diagonal and paralleling the printed circuit board, a helical spring coiling the pole of each pin between the pin head and the printed circuit board.

In the above methods, adhesive may be epoxy glue. The electronic device may be a Ball Grid Array package, a Quad Flat No leads package, a Small Outline Package, or a Chip Support Package.

### BRIEF DESCRIPTION OF THE DRAWINGS

FIG.1A is an isometric view of a conventional frequently used instance of mounting a heat sink to a PCB;
FIG.1B is a front view showing the conventional frequently used instance of mounting a heat sink to a PCB in Fig.1A;
FIG.1C is a front view showing the conventional frequently used heat sink assembly of Fig.1A drops and the springs are compressed;
FIG.1D is a front view showing the conventional frequently used heat sink assembly of Fig.1A drops and the spring tension is released;
FIG.2 is an isometric view of a heat sink assembly with glue according to an embodiment;
FIG.3A is a top view of the heat sink with glue in Fig. 2;
FIG.3B is a bottom view of the heat sink with glue in Fig.2;
FIG.4 is a front view of the heat sink assembly of Fig. 2, Figs.3A and 3B;
FIG.5 is an isometric view of a heat sink assembly according to a variant embodiment;
FIG.6A is a top view of the heat sink with glue in Fig. 5;
FIG.6B is a bottom view of the heat sink with glue in Fig. 5;
FIG.7 isometric view of a heat sink assembly according to another variant embodiment;
FIG.8A is a top view of the heat sink with glue in Fig. 7;
FIG.8B is a bottom view of the heat sink with glue in Fig.7; and
FIG.9 is a flow chart illustrating how to mounting the heat sink to the BGA and further to the PCB.

### DETAILED DESCRIPTION OF THE INVENTION

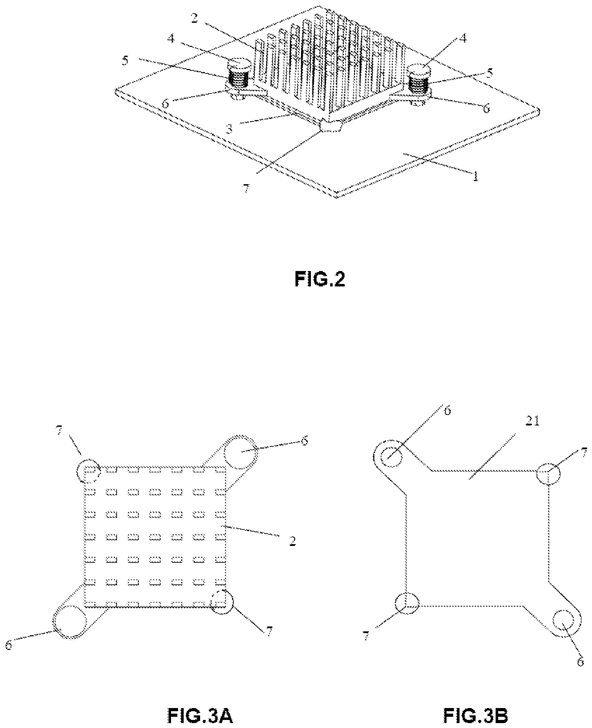

Fig. 2 shows a heat sink assembly mounted on a BGA IC package and further on a PCB according to an embodiment. The IC package 3 is fixed to a printed circuit board 1 in Ball Grid Array (BGA) way, and a heat sink 2 is mounted on the surface of the IC package 3 and further to the printed circuit board 1. Two tabs 6 with apertures (not shown) thereon are extended paralleling the PCB 1 from two diagonal corners of the heat sink 2. Through the apertures on the two tabs 6, two arrow-ended pins 4 with helical springs 5 coiled thereon and between the pin head and the tabs 6 are inserted to fasten the heat sink 2 to the PCB 1. While an adhesive element, e.g. glue 7, is used at the other two corners than the two corners with the tabs of the heat sink to further fasten it to the PCB. This glue is epoxy. The glue in Fig.2 is exaggeratedly drawn to illustrate the present principle, and should not be construed as limitation to the invention. By gluing the heat sink to the PCB, the glue will act as a stiffener to constrain the movement or flexing which prevents strain generated to the solder balls of the BGA.

Fig. 3A is a top view of the heat sink 2 and the glue 7 in Fig.2. The dashed lines in Fig.3A show the part of glue that spreads between the back of the heat sink 2 and the PCB 1 and can't be seen from the top. Fig. 3B is a bottom view of heat sink 2 with the glue 7, wherein sign 21 indicating the bottom surface of the heat sink.

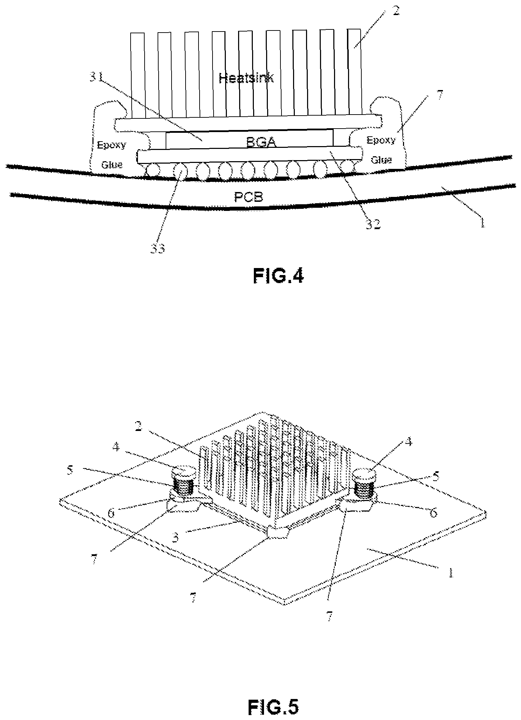

Fig.4 is a front view further showing how the glue is used in Fig.2, Fig.3A and Fig.3B. IC chip 31, substrate 32 and solder balls 33 constitute the BGA IC package 3. A part of the bottom surface of the heat sink 2 is exposed to the PCB 1. In Fig.4, this part is the periphery of the bottom of the heat sink 2. The glue can be spotted between the two corners of the bottom surface of the heat sink 2 exposed to the PCB 1 and the PCB 1, or even stick the substrate 32, or further extend to the side face of IC chip 31 (not shown).

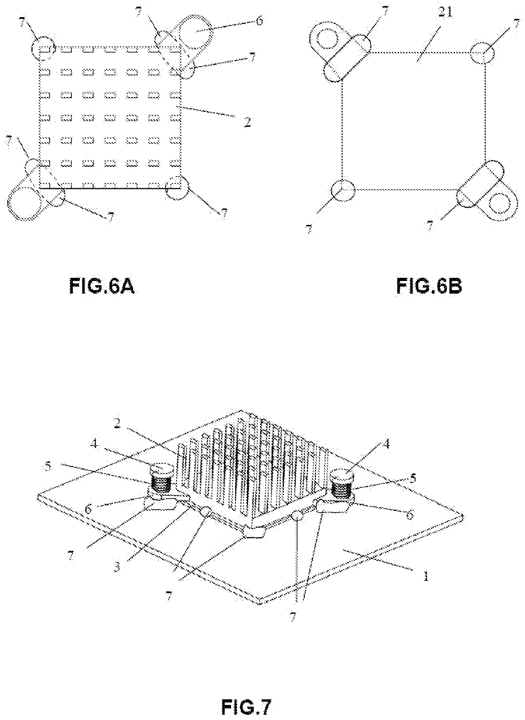

In a variant embodiment as shown in Fig.5, Fig.6A, and Fig.6B, glue 7 is used at the four corners of the bottom surface of the heat sink 2 exposed to the PCB 1 to stick the heat sink on the PCB 1. Fig.5 is the isometric view of the variant embodiment. Fig. 6A is the top view of the heat sink 2 with glue 7 in Fig.5. Dashed lines show invisible part of the glue at the back of the heat sink 2 and can't be seen from the top. Fig. 6B is the bottom view of the heat sink 2 with glue in Fig.5.

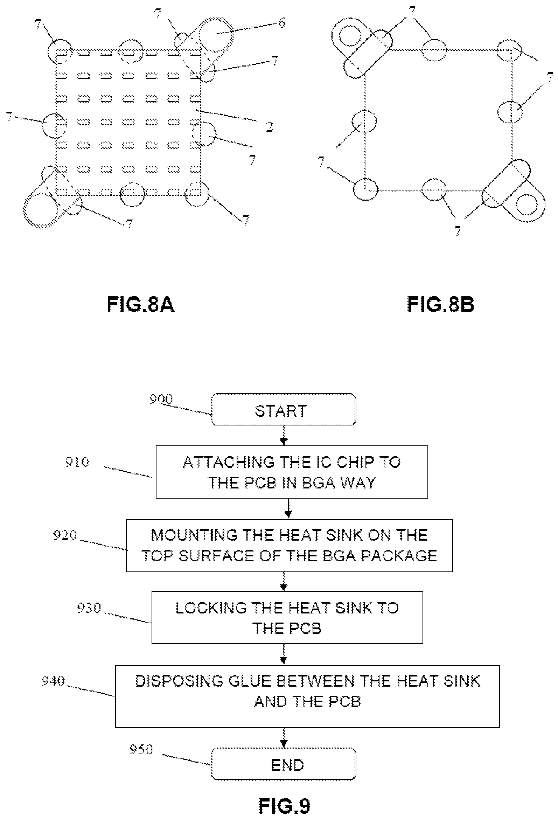

In still another variant embodiment shown in Fig.7, Fig.8A and Fig.8B, glue7 is used at the four corners and four edges of the bottom surface of the heat sink 2 exposed to the PCB1. Space is preferred to be reserved between the IC board and the PCB to facilitate the heat dissipating. Fig.7 is the isometric view. Fig. 8A is the top view of the heat sink 2 with glue 7 in Fig.7. Dashed lines show invisible part of the glue at the back of the heat sink 2 and can't be seen from the top. Fig. 8B is the bottom view of the heat sink 2 with glue in Fig.7.

Fig. 9 is a flow chart showing how to mount the heat sink assembly. As is seen from Fig.9, the process starts at step 900 and ends at step 950. At step 910, the IC chip is attached to the PCB in BGA way. Then at step 920, the heat sink 2 is mounted on the surface of the BGA IC package 3. At step 930, two arrow-ended pins 4 are inserted in the two apertures of the two tabs 6 extending paralleling the PCB 1 from the bottom of the heat sink 2 to lock the heat sink 2 to the PCB.1. Afterwards, at step 940, glue 7 is disposed between the heat sink 2 and the PCB 1.

The glue specified in above embodiments may be any type of epoxy glue which may not harm the PCB & BGA in any chemical reaction.

Above embodiments are illustrated by using BGA IC package, and the present principle can be used to other IC packages, for example, QFN(Quad Flat No leads), SOP(Small Outline Package), or CSP(Chip Support Package).

In above embodiment, the heat sink has a rectangular bottom. However, for heat sinks with other shapes of bottom, e.g. round, polygon, the present principle can be used too. For example, if the heat sink has a round bottom, two tabs can extend paralleling the PCB in from two diametric points of the heat sink bottom, and glue can be used at several points of periphery of a round shaped heat sink.

In above embodiments, though the part of the bottom of the heat sink 2 that is exposed to the PCB 1 is the periphery of the bottom, it can be other parts, e.g. middle of the bottom of the heat sink. In the latter situation, there should be a corresponding part on the PCB so that the glue can be put between the two parts to force the heat sink adhere to the PCB.

In addition, though above embodiments and drawings show most of the adhesive parts (glue) are of round shape, they can be other shapes too, e.g. stripe, or even of irregular shapes.

Other than above embodiments, glue can be used to fasten a heat sink to a PCB without the pins or to fasten a heat sink in a different way, e.g. using a string spring. The present invention is, however, defined in the appended claims.

## Claims

1. A heat dissipating assembly, including
a printed circuit board (1),
an electronic device (3), attached to the printed circuit board (1),
a heat dissipating apparatus(2), the bottom (21) of which is attached to the surface of the electronic device(3) and has at least a part exposed to the printed circuit board (1), the heat dissipating apparatus (2) comprising two tabs (6) extending from the bottom (21) and paralleling the printed circuit board (1) and two pins (4) inserted through the two tabs (6) respectively to lock the heat dissipating apparatus (2) to the printed circuit board (1), with a helical spring coiling the pole of each pin between the pin head and the printed circuit board (930), and
**characterised by** at least one adhesive element (7), disposed between the part of the bottom (21) exposed to the printed circuit board (1) and the printed circuit board(1) to make the heat dissipating apparatus (2) adhere to the printed circuit board (1).

2. The heat dissipating assembly according to claim 1, wherein the heat dissipating apparatus (2) comprises
the two tabs (6) extending diametrically from the bottom (21) when the bottom (21) is of round shape.

3. The heat dissipating assembly according to claim 1, wherein the heat dissipating apparatus (2) comprises
the two tabs (6) extending diagonally from two corners of the bottom (21) when the bottom (21) is of rectangular shape.

4. The heat dissipating assembly according to claim 3, wherein the at least one adhesive element (7) is disposed at the two corners of the bottom (21) of the heat dissipating apparatus (2) which do not have a tab to make the heat dissipating apparatus (2) adhere to the printed circuit board (1).

5. The heat dissipating assembly according to claim 3, wherein the at least one adhesive element (7) is disposed at the four corners and the edges of the heat dissipating apparatus (2) to make the heat dissipating apparatus (2) adhere to the printed circuit board (1).

6. The heat dissipating assembly according to any of claims 1 to 5, wherein the at least one adhesive element (7) is epoxy glue.

7. The heat dissipating assembly according to any of claims 1 to 6, wherein the electronic device is a Ball Grid Array package, a Quad Flat No leads package, a Small Outline Package, or a Chip Support Package.

8. A method for mounting a heat dissipating apparatus to a printed circuit board, comprising steps of
attaching an electronic device to the printed circuit board (910);
mounting the heat dissipating apparatus on the electronic device, the bottom of the heat dissipating apparatus being attached to the surface of the electronic device and having at least a part exposed to the printed circuit board (920),
locking the heat dissipating apparatus to the printed circuit board by using two pins through two tabs extending diagonal and paralleling the printed circuit board, a helical spring coiling the pole of each pin between the pin head and the printed circuit board (930), and **characterised by** the further step of disposing adhesive between the part of the bottom exposed to the printed circuit board and the printed circuit board to make the heat dissipating apparatus adhere to the printed circuit board (940).

9. The method according to claim 8, wherein the adhesive is epoxy glue.

10. The method or according to claim 8 or 9, wherein the electronic device is a Ball Grid Array package, a Quad Flat No leads package, a Small Outline Package, or a Chip Support Package.

## Patentansprüche

1. Wärmeableitanordnung, die enthält:
eine Leiterplatte (1),
eine elektronische Vorrichtung (3), die an der Leiterplatte (1) befestigt ist,
eine Wärmeableiteinrichtung (2), deren Unterseite (21) an der Oberfläche der elektronischen Vorrichtung (3) befestigt ist und mindestens einen Teil aufweist, der zu der Leiterplatte (1) freiliegt, wobei die Wärmeableiteinrichtung (2) zwei Nasen (6) umfasst, die von der Unterseite (21) ausgehen und parallel zu der Leiterplatte (1) sind, und wobei durch die zwei Nasen (6) zwei Stifte (4) eingeführt sind, die die Wärmeableiteinrichtung (2) jeweils an der Leiterplatte (1) verriegeln, wobei zwischen dem Stiftkopf und der Leiterplatte (930) eine Schraubenfeder um den Schaft jedes Stifts gewickelt ist, und
**gekennzeichnet durch** mindestens ein Haftelement (7), das zwischen dem Teil der Unterseite (21), der zu der Leiterplatte (1) freiliegt, und der Leiterplatte (1) angeordnet ist, um zu veranlassen, dass die Wärmeableiteinrichtung (2) an der Leiterplatte (1) haftet.

2. Wärmeableitanordnung nach Anspruch 1, wobei die Wärmeableiteinrichtung (2) umfasst,
dass die zwei Nasen (6) von der Unterseite (21) diametral ausgehen, wenn die Unterseite (21) eine runde Form aufweist.

3. Wärmeableitanordnung nach Anspruch 1, wobei die Wärmeableiteinrichtung (2) umfasst,
dass die zwei Nasen (6) von zwei Ecken der Unterseite (21) diagonal ausgehen, wenn die Unterseite (21) eine rechteckige Form aufweist.

4. Wärmeableitanordnung nach Anspruch 3, wobei das mindestens eine Haftelement (7) an den zwei Ecken der Unterseite (21) der Wärmeableiteinrichtung (2) angeordnet ist, die keine Nase aufweisen, um zu veranlassen, dass die Wärmeableiteinrichtung (2) an der Leiterplatte (1) haftet.

5. Wärmeableitanordnung nach Anspruch 3, wobei das mindestens eine Haftelement (7) an den vier Ecken und an den Rändern der Wärmeableiteinrichtung (2) angeordnet ist, um zu veranlassen, dass die Wärmeableiteinrichtung (2) an der Leiterplatte (1) haftet.

6. Wärmeableitanordnung nach einem der Ansprüche 1 bis 5, wobei das mindestens eine Haftelement (7) ein Epoxidklebstoff ist.

7. Wärmeableitanordnung nach einem der Ansprüche 1 bis 6, wobei die elektronische Vorrichtung eine Ball-Grid-Array-Baugruppe, eine Quad-Flat-No-Leads-Baugruppe, eine Small-Outline-Baugruppe oder eine Chip-Support-Baugruppe ist.

8. Verfahren zum Montieren einer Wärmeableiteinrichtung an einer Leiterplatte, wobei das Verfahren die folgenden Schritte umfasst:
Befestigen einer elektronischen Vorrichtung an der Leiterplatte (910);
Montieren der Wärmeableiteinrichtung an der elektronischen Vorrichtung, wobei die Unterseite der Wärmeableiteinrichtung an der Oberfläche der elektronischen Vorrichtung befestigt wird und mindestens einen Teil aufweist,
der zu der Leiterplatte (920) freiliegt,
Verriegeln der Wärmeableiteinrichtung an der Leiterplatte unter Verwendung zweier Stifte durch zwei Nasen, die diagonal verlaufen und zu der Leiterplatte parallel sind,
wobei zwischen dem Stiftkopf und der Leiterplatte (930) eine Schraubenfeder um den Schaft jedes Stifts gewickelt wird, und
**gekennzeichnet durch** den weiteren Schritt des Anordnens von Klebstoff zwischen dem Teil der Unterseite, der zu der Leiterplatte freiliegt, und der Leiterplatte, um zu veranlassen, dass die Wärmeableiteinrichtung an der Leiterplatte (940) haftet.

9. Verfahren nach Anspruch 8, wobei der Klebstoff ein Epoxidklebstoff ist.

10. Verfahren nach Anspruch 8 oder 9, wobei die elektronische Vorrichtung eine Ball-Grid-Array-Baugruppe, eine Quad-Flat-No-Leads-Baugruppe, eine Small-Outline-Baugruppe oder eine Chip-Support-Baugruppe ist.

## Revendications

1. Dispositif de dissipation de chaleur comprenant une carte de circuit imprimé (1),
un dispositif électronique (3) fixé à la carte de circuit imprimé (1),
un appareil de dissipation de chaleur (2), dont le fond (21) est fixé à la surface du dispositif électronique (3) et a au moins une partie exposée à la carte de circuit imprimé (1), l'appareil de dissipation de chaleur (2) comprenant deux pattes (6) qui s'étendent depuis le fond (21) et parallèlement à la carte de circuit imprimé (1) et deux tiges (4) insérées dans les deux pattes (6) respectivement pour maintenir l'appareil de dissipation de chaleur (2) sur la carte de circuit imprimé (1), avec un ressort hélicoïdal enroulé autour de chaque tige entre la tête de la tige et la carte de circuit imprimé (930), et
**caractérisé par** au moins un élément adhésif (7) placé entre la partie du fond (21) exposée à la carte de circuit imprimé (1) et la carte de circuit imprimé (1) pour que l'appareil de dissipation de chaleur (2) adhère à la carte de circuit imprimé (1).

2. Dispositif de dissipation de chaleur selon la revendication 1, dans lequel l'appareil de dissipation de chaleur (2) comprend
les deux pattes (6) qui s'étendent dans des directions diamétralement opposées depuis le fond (21)
lorsque le fond (21) est de forme ronde.

3. Dispositif de dissipation de chaleur selon la revendication 1, dans lequel l'appareil de dissipation de chaleur (2) comprend
les deux pattes (6) qui s'étendent en diagonale depuis deux coins du fond (21) lorsque le fond (21) est de forme rectangulaire.

4. Dispositif de dissipation de chaleur selon la revendication 3, dans lequel le au moins un élément adhésif (7) est placé aux deux coins du fond (21) de l'appareil de dissipation de chaleur (2) qui ne présentent pas de pattes pour que l'appareil de dissipation de chaleur (2) adhère à la carte de circuit imprimé (1).

5. Dispositif de dissipation de chaleur selon la revendication 3, dans lequel le au moins un élément adhésif (7) est placé aux quatre coins et sur les bords de l'appareil de dissipation de chaleur (2) pour que l'appareil de dissipation de chaleur (2) adhère à la carte de circuit imprimé (1).

6. Dispositif de dissipation de chaleur selon l'une des revendications 1 à 5, dans lequel le au moins un élément adhésif (7) est une colle époxy.

7. Dispositif de dissipation de chaleur selon l'une des revendications 1 à 6, dans lequel le dispositif électronique est un boîtier BGA (Ball Grid Array), QFN (Quad Flat No leads), SO (Small Outline) ou CS (Chip Support).

8. Procédé de montage d'un appareil de dissipation de chaleur sur une carte de circuit imprimé, comprenant les étapes suivantes :
fixation d'un dispositif électronique à la carte de circuit imprimé (910) ;
montage de l'appareil de dissipation de chaleur sur le dispositif électronique, le fond de l'appareil de dissipation de chaleur étant fixé à la surface du dispositif électronique et ayant au moins une partie exposée à la carte de circuit imprimé (920),
maintien de l'appareil de dissipation de chaleur sur la carte de circuit imprimé à l'aide de deux tiges insérées dans deux pattes qui s'étendent en diagonale et parallèlement à la carte de circuit imprimé, d'un ressort hélicoïdal enroulé autour de chaque tige entre la tête de la tige et la carte de circuit imprimé (930), et
**caractérisé par** l'étape supplémentaire suivante :
positionnement d'un adhésif entre la partie du fond exposée à la carte de circuit imprimé et la carte de circuit imprimé pour que l'appareil de dissipation de chaleur adhère à la carte de circuit imprimé (940).

9. Procédé selon la revendication 8, dans lequel l'adhésif est une colle époxy.

10. Procédé selon la revendication 8 ou 9, dans lequel le dispositif électronique est un boîtier BGA (Ball Grid Array), QFN (Quad Flat No leads), SO (Small Outline) ou CS (Chip Support).
